# EUROPÄISCHE PATENTSCHRIFT

(11) **EP 2 590 891 B1**
(45) Veröffentlichungstag und Bekanntmachung des Hinweises auf die Patenterteilung: **02.03.2016**
(21) Anmeldenummer: 11724604.1
(22) Anmeldetag: 01.06.2011
(51) Int. Cl.: B81C 1/00, B01L 3/00

(54) **VERFAHREN ZUR HERSTELLUNG EINES INTEGRIERTEN MIKROFLUIDISCHEN SYSTEMS**
METHOD FOR PRODUCING AN INTEGRATED MICROFLUIDIC SYSTEM
PROCÉDÉ DE FABRICATION D'UN SYSTÈME MICROFLUIDIQUE INTÉGRÉ

(30) Priorität: 08.07.2010 DE 102010031103
(43) Veröffentlichungstag der Anmeldung: 15.05.2013
(73) Patentinhaber: Robert Bosch GmbH, 70442 Stuttgart (DE)
(72) Erfinder: SCHAAF, Ulrich, 73667 Kaisersbach (DE); HOFFMANN, Jana, 70771 Leinfelden-Echterdingen (DE); SUNDERMEIER, Frieder, 70806 Kornwestheim (DE); MAY, Johanna, 71634 Ludwigsburg (DE)
(86) Internationale Anmeldenummer: PCT/EP2011/059083
(87) Internationale Veröffentlichungsnummer: WO 2012/004066

(56) Entgegenhaltungen:
- DE-A1- 10 122 133
- US-A1- 2010 154 519
- POPLAWSKI M E ET AL: "A SIMPLE PACKAGING PROCESS FOR CHEMICAL SENSORS", TECHNICAL DIGEST, IEEE SOLID-STATE SENSOR & ACTUATOR WORKSHOP, NEW YORK, NY, US, 13. Juni 1994 (1994-06-13), Seiten 25-28, XP001121593,

## Beschreibung

Die vorliegende Erfindung betrifft ein Verfahren zur Herstellung eines integrierten mikrofluidischen Systems, welches mindestens ein mikrofluidisches Substrat und mindestens ein damit verbundenes fluidisch und elektrisch kontaktiertes Elektronik-Substrat, insbesondere einen Halbleiterchip, umfasst, wobei die fluidische und die elektrische Anbindung mittels eines Flip-Chip-Prozesses mit nacheinander auszuhärtenden Klebemitteln hergestellt werden. Die Erfindung betrifft weiterhin ein integriertes mikrofluidisches System und dessen Verwendung.

### Stand der Technik

Mikrofluidische Systeme finden insbesondere in der Biotechnologie, der analytischen, pharmazeutischen und klinischen Chemie, der Umweltanalytik und Lebensmittelchemie sich rasant entwickelnde Anwendungsbereiche. Sie kommen beispielsweise in Form von miniaturisierten Analysesystemen, so genannten µTAS (Miniaturized Total Analysis System) sowie als Lab-on-Chip-System oder als Mikroreaktoren zum Einsatz. Um die Funktionalitäten solcher mikrofluidischer Systeme zu erweitern und zu verbessern sind Kombinationen mit Halbleiterbauelementen, so genannte integrierte mikrofluidische Systeme, entwickelt worden.

In der Patentschrift DE 101 22 133 B4 wird ein integriertes Mikrosystem beschrieben, welches eine mikrofluidische Komponente und einen integrierten Schaltungschip umfasst. Der integrierte Schaltungschip ist mit der mikrofluidischen Komponente dabei unter Verwendung einer Flip-Chip-Verbindung, beispielsweise einer Lötmittelhöckerbefestigung, einer Goldplattierungsbefestigung oder einer Befestigung durch ein leitfähiges Haftmittel, verbunden.

In der Veröffentlichung von Paul Galambos et al., "Electrical and Fluidic Packaging of Surface Micromachined Electro-Microfluidic Devices" ist ein zweistufiger Packaging-Prozess zur Herstellung eines integrierten mikrofluidischen Packages beschrieben, bei dem gleichzeitig eine fluidische und eine elektrische Ankontaktierung ermöglicht wird. Hierbei wird in einem ersten Schritt ein integriertes mikrofluidisches Modul (MIC, Microfluidic Integrated Circuit) mit einem Electro-Mikrofluidic Dual Inline Package (EMDIP) elektrisch und fluidisch verbunden. Die elektrische Verbindung wird mittels Drahtbonden oder einer Flip-Chip-Verbindung hergestellt. Die fluidische Verbindung wird durch passgenaues Fügen von mikrofluidischen Öffnungen in beiden Verbindungspartnern erzielt. In einem zweiten Schritt wird dann das EMDIP an eine fluidische Leiterplatte angeschlossen, welche Buchsen für die elektrischen Anschlüsse des EMDIP und fluidische Kanäle zur Verbindung mit den fluidischen Zugängen des EMDIP aufweist. Zur fluidischen Abdichtung zwischen EMDIP und der fluidischen Leiterplatte wird vorgeschlagen O-Ring-Dichtungen oder Klebeband zu verwenden.

Das Dokument Poplawski et al "A Simple Packaging Process For Chemical Sensors", Technical Digest, IEEE Solid-State Sensor & Actuator Workshop, New York, NY, US, 13. Juni 1994, Seiten 25-28 beschreibt die Herstellung eines Silizium-basierten chemischen Sensor arrays, wobei ein mikrofluidisches Subststrat und ein Elektroniksubstrat so verbunden werden, dass in den beiden Substraten angeordnete fluidische und elektronische Anschlusselemente sich jeweils überlappen. Die fluidische Kontaktierung und Abdichtung erfolgt dabei durch ein Silikon-Dichtmittel, während die elektronische Kontaktierung über ein Silber-Epoxid-Leitmittel erzielt wird.

### Offenbarung der Erfindung

Erfindungsgemäß wird ein Verfahren zur Herstellung eines integrierten mikrofluidischen Systems, mindestens umfassend ein mikrofluidisches Substrat und ein Elektronik-Substrat, insbesondere einen Halbleiterchip, wobei das mikrofluidische Substrat und das Elektronik-Substrat jeweils mindestens ein fluidisches Anschlusselement und mindestens ein elektrisches Anschlusselement auf einer Verbindungsoberfläche aufweisen, mittels einer Flip-Chip-Verbindung, dadurch gekennzeichnet, dass es folgende Schritte umfasst:
A) Aufbringen eines fluidisch abdichtenden Klebemittels zur Herstellung einer fluidischen Kontaktierung auf die Verbindungsoberfläche des mikrofluidischen Substrats und/oder des Elektronik-Substrats,
B) Aufbringen eines zweiten Klebemittels (6) zur elektrischen Verbindung auf die Verbindungsoberfläche des mikrofluidischen Substrats und/oder des Elektronik-Substrats, wobei das zweite Klebemittel vom ersten Klebemittel verschieden ist,
C) Aufsetzen und Andrücken des Elektronik-Substrats mit seiner Verbindungsoberfläche auf die Verbindungsoberfläche des mikrofluidischen Substrats mit einem definierten Anpressdruck, wobei jeweils die fluidischen Anschlusselemente und elektrischen Anschlusselemente zur fluidischen und elektrischen Kontaktierung mindestens teilweise überlappend angeordnet sind und
D) Aushärten des ersten und des zweiten Klebemittels wobei das zweite Klebemittel, insbesondere unter dem in Schritt C) ausgeübten definierten Anpressdruck, zuerst aushärtet.

Mit anderen Worten kann erfindungsgemäß die konventionelle und etablierte Flip-Chip-Montage mit geringen Anpassungen vorteilhafterweise für die gleichzeitige fluidische Anbindung und Abdichtung sowie für die elektrisch funktionelle Anbindung von Elektronik-Substraten, insbesondere Halbleiterchips, an mikrofluidische Substrate verwendet werden. Die gleichzeitige fluidische und elektrische Ankontaktierung wird dabei im bereitgestellten Flip-Chip-Verfahren über einen zweistufigen Klebeprozess realisiert, wobei das Klebemittel für die elektrische Ankontaktierung zuerst und dann nachfolgend das Klebemittel für die fluidisch dichte Anbindung aushärtet.

Ein mikrofluidisches Substrat weist erfindungsgemäß mindestens ein mikrofluidisches Anschlusselement, beispielsweise eine Membran oder eine Zugangsöffnung zu einer mikrofluidischen Struktur, auf. Mikrofluidische Strukturen im Sinne der Erfindung können zum Beispiel mikrofluidische Kanäle, Kammern, Verweilstrukturen, Mikromischer, mikrofluidische Pumpen, Ventile oder Sensoren sein. Erfindungsgemäß bevorzugt ist das mikrofluidische Substrat aus einem polymeren Material gefertigt.

Das mikrofluidische Substrat weist erfindungsgemäß außerdem mindestens ein elektrisches Anschlusselement auf, welches sich auf der gleichen Oberflächenseite des Substrats befindet, wie das mikrofluidische Anschlusselement. Ein elektrisches Anschlusselement kann erfindungsgemäß beispielsweise eine Metallisierung auf einer Oberfläche des mikrofluidischen Substrats sein. Die Metallisierung kann beispielhaft als Kontaktpad oder als Leiterbahn ausgestaltet sein. Solche Metallisierungen können auf einfache Weise durch geeignete und etablierte Verfahren aufgebracht werden, wie zum Beispiel durch Sputtern, Heißprägen, chemische oder galvanische Prozesse. Zusätzlich kann das mikrofluidische Substrat auch integrierte elektrische Leiterstrukturen, wie Leiterbahnen aufweisen.

Als Verbindungsseiten werden erfindungsgemäß die im fertig gestellten integrierten mikrofluidischen System zueinander gewandten und mindestens teilweise miteinander verbundenen Oberflächen des mikrofluidischen Substrats und des Elektronik-Substrats bezeichnet.

Zweckmäßigerweise wird der Abstand zwischen den fluidischen und elektrischen Anschlusselementen auf den jeweiligen Verbindungsseiten der mikrofluidischen Substrate und der Elektronik-Substrate erfindungsgemäß so gewählt, dass ein Kurzschluss durch ein, in das fertig gestellte integrierte mikrofluidische System eingebrachtes, Fluid ausgeschlossen ist.

Ein erfindungsgemäßes mikrofluidisches Substrat kann insbesondere durch bekannte etablierte mikrotechnologische Verfahren hergestellt werden. Zum Beispiel kann ein platten- oder folienförmiges Substrat verwendet werden. Beispielsweise kann dies ein Glassubstrat, ein Siliziumsubstrat, ein Leiterplattensubstrat oder vorzugsweise ein Polymersubstrat, insbesondere ein Pyrexsubstrat, ein Teflonsubstrat, ein Polystyrolsubstrat, ein Substrat aus einem Cyclo-Olefin-Copolymer, ein Polyestersubstrat oder ein PDMS-Substrat, oder ein durch Spritzgießen oder Tiefenätzen oder Prägen, insbesondere Heißprägen, strukturiertes Substrat, beispielsweise ein strukturiertes Glassubstrat, Siliziumsubstrat oder Polymersubstrat, insbesondere ein Pyrexsubstrat, ein Teflonsubstrat, ein Polystyrolsubstrat, ein Substrat aus einem Cyclo-Olefin-Copolymer, ein Polyestersubstrat oder ein PDMS-Substrat sein. Das mikrofluidische Substrat kann auch aus mehreren, miteinander gefügten, Schichten aufgebaut sein.

Das Elektronik-Substrat ist erfindungsgemäß vorzugsweise ein Halbleiterchip, der auf derselben Seite mindestens ein fluidisches und ein elektrisches Anschlusselement aufweist. Das fluidische Anschlusselement kann insbesondere eine Membran, eine Kanalstruktur oder ein Ventil sein. Die elektrischen Anschlusselemente können für die Flip-Chip-Montage geeignete Kontaktierhügel (Bumps) sein. Bevorzugt werden erfindungsgemäß auf der Verbindungsseite des Elektronik-Substrats abgerissene und anschließend gecointe Drahtbonddrähte, so genannte Stud-Bumps, besonders bevorzugt aus Gold, als elektrische Anschlusselemente eingesetzt.

Beispielhaft kann das erfindungsgemäße Elektronik-Substrat ein Fluss-Sensor sein, der mit einer Membran als fluidisches Anschlusselement und auf derselben Oberflächenseite mit Stud-Bumps als elektrische Anschlusselemente ausgestaltet ist. Die Membran kann dann erfindungsgemäß im fertig gestellten integrierten mikrofluidischen System vorteilhafterweise von einem Fluid auf derselben Seite angeströmt werden, auf der auch die Gold-Stud-Bumps, beispielsweise mit Leiterbahnen als elektrische Anschlusselemente, auf einem mikrofluidischen Substrat ankontaktiert werden.

Klebemittel im Sinne der Erfindung sind zunächst fließfähige Klebstoffe, die auf eine Verbindungsseite des mikrofluidischen Substrats und/oder des Elektronik-Substrats aufgetragen werden können. Erfindungsgemäß ist vorgesehen, dass die Klebemittel dabei derart aufeinander abgestimmt sind, dass unter den gewählten Prozessbedingungen, insbesondere auch unter dem gewählten Anpressdruck in Schritt C), das zweite Klebemittel für die elektrische Kontaktierung zuerst aushärtet und erst nachfolgend die Aushärtung des ersten Klebemittels zur fluidisch dichten Kontaktierung erfolgt, beziehungsweise jeweils die Aushärtung der Klebemittel in der genannten Reihenfolge herbeigeführt wird.

Mögliche, erfindungsgemäß geeignete, Klebemittel-Systeme aus erstem und zweitem Klebemittel sind unterschiedliche licht- bzw. temperaturhärtende Klebestoffe oder Kombinationen daraus. So kann zum Beispiel das zweite Klebemittel zunächst thermisch ausgehärtet werden und nachfolgend das erste fluidisch abdichtende Klebemittel mit UV-Licht. Alternativ kann das zweite Klebemittel ein thermisch schnell reaktiver Klebstoff sein, während als das erste fluidisch abdichtende Klebemittel ein thermisch langsam härtender Klebstoff gewählt wird. Ebenfalls ist die Alternative möglich, dass das zweite Klebemittel durch Reaktion von zwei Komponenten schnell, beispielsweise innerhalb einer Stunde, aushärtet, während das erste Klebemittel, beispielsweise mithilfe von Luftfeuchtigkeit über einen Zeitraum von zwölf oder mehr Stunden härtet.

Mit dem vorgeschlagenen erfindungsgemäßen Verfahren kann ein Elektronik-Substrat, beispielsweise ein Halbleiterchip, dessen elektrische Kontakte sich auf derselben Seite befinden wie dessen fluidische Anschlüsse, auf einfache Weise an ein mikrofluidisches Substrat mit fluidischen Anschlusselementen und elektrischen Anschlusselementen, die ebenfalls auf derselben Seite angeordnet sind, ankontaktiert werden. Vorteilhafterweise ergibt sich, insbesondere durch die zweistufige Aushärtung der beiden erfindungsgemäßen Klebemittel, eine sichere, elektrisch funktionelle und eine fluidisch dichte Kontaktierung der beiden Substrate.

Im Rahmen einer Ausgestaltung des erfindungsgemäßen Verfahrens kann die Aufbringung des ersten und des zweiten Klebemittels in Schritt A) und B), insbesondere gleichzeitig, bevorzugt auf der Verbindungsoberfläche des mikrofluidischen Substrats erfolgen. Vorteilhafterweise kann die Aufbringung der verschiedenen Klebemittel also in einem Prozessschritt durchgeführt werden.

In einer weiteren Ausführungsform kann die Aufbringung der Klebemittel in Schritt A) und Schritt B) durch einen Dispens- und/oder einen Stempelprozess und/oder einen Jetprozess erfolgen. Diese Prozesse sind besonders gut für die Auftragung unterschiedlicher Klebemittel geeignet. Zudem bieten diese Auftragungsmethoden die Möglichkeit der einfachen Automatisierung der Verfahrensschritte A) und B). Dies ist besonders vorteilhaft für eine Anwendung im industriellen Maßstab und eine Serienfertigung integrierter mikrofluidischer Systeme. Ein besonderer Vorteil ergibt sich auch daraus, dass der Auftrag der Klebemittel mittels der genannten Prozesse in der gleichen automatisierten Anlage erfolgen kann, wie ein, erfindungsgemäß ebenfalls mögliches, automatisiertes Aufsetzen und Andrücken des Elektronik-Substrats auf das mikrofluidische Substrat in Schritt C).

Im Rahmen einer anderen erfindungsgemäßen Verfahrensvariante wird das Aushärten in Schritt D) in einem Temperaturbereich bis maximal 150 °C, beispielsweise bei einer Temperatur ≤ 120 °C, durchgeführt. Mit anderen Worten wird erfindungsgemäß damit auch ein Nieder-Temperatur-Verfahren zur gleichzeitigen fluidischen und elektrischen Anbindung von Elektronik-Substraten, beispielsweise Silizium-Chips, an mikrofluidische Substrate bereitgestellt. Vorteilhaft ist daran, dass auch mikrofluidische Polymersubstrate verwendbar sind, die bei höheren Temperaturen deformieren würden, wie zum Beispiel Polymersubstrate aus Polycarbonat.

Zweckmäßigerweise kann erfindungsgemäß ein erstes fluidisch abdichtendes Klebemittel gewählt werden, welches unter den gewählten Prozessbedingungen, insbesondere den gegebenenfalls notwendigen Temperatureinwirkungen und dem gewählten Anpressdruck in Schritt C), nicht kapillarisiert. Hierdurch kann vorteilhafterweise verhindert werden, dass fluidische Zugangsöffnungen verstopfen.

Im Rahmen einer anderen erfindungsgemäßen Ausgestaltung des Verfahrens kann ein zweites Klebemittel verwendet werden, das beim Aushärten in Schritt D) einer Schrumpfung unterliegt. Das zweite Klebemittel kann auf diese Weise vorteilhaft dazu beitragen, die elektrischen Anschlusselemente, wie Kontaktierhügel (Bumps), des Halbleiterelements auf die Anschlusselemente auf der Verbindungsseite des mikrofluidischen Substrats zu ziehen und so den elektrischen Kontakt zwischen den elektrischen Anschlusselementen herzustellen und/oder zu unterstützen. Hierdurch kann eine zuverlässige und dauerhafte elektrische Kontaktierung gewährleistet werden. Weiter bevorzugt kann das zweite Klebemittel eine niedrige Aushärtetemperatur, bevorzugt bis maximal 150 °C aufweisen. Beispielsweise kann das zweite Klebemittel eine Aushärtetemperatur ≤ 120 °C aufweisen. Besonders bevorzugt wird als zweites Klebemittel ein elektrisch nicht leitender Klebstoff verwendet.

Das erste und das zweite Klebemittel können beispielsweise Klebstoffe sein, die ausgewählt sind aus der Gruppe, bestehend aus Epoxidharzen, Polyurethanklebstoffen, Acrylaten, Silikonen und/oder Mischformen der genannten Klebstoffe. Erfindungsgemäß wesentlich ist dabei, dass sich die Aushärtemechanismen des ausgewählten ersten Klebstoffs und des zweiten Klebstoffs derart unterscheiden, dass im erfindungsgemäßen Verfahren zuerst eine Aushärtung des zweiten Klebemittels zur elektrisch funktionellen Kontaktierung erfolgt, beziehungsweise herbeigeführt werden kann.

In einer anderen Ausführungsvariante des Verfahrens gemäß der Erfindung ist vorgesehen, dass das Aufsetzen des Elektronik-Substrats mit seiner Verbindungsoberfläche auf die Verbindungsoberfläche des mikrofluidischen Substrats in Schritt C), anhand optischer Erkennungsmarken, insbesondere der elektrischen Anschlusselemente, auf der Verbindungsoberfläche des mikrofluidischen Substrats erfolgt. Vorteilhafterweise kann die Ausrichtung der Elektronik-Substrate vor und beim Aufsetzen auf das mikrofluidische Substrat auf einfache Weise, insbesondere auch automatisiert, erfolgen. Aufwändige Ausrichtungsprozesse (Alignmentprozesse) können gänzlich vermieden werden. Zudem kann bei einer automatisierten Durchführung des Schritts C) die Ankontaktierung der Fügepartner, also des mikrofluidischen Substrats und des Elektronik-Substrats, besonders exakt und präzise erfolgen. Eine Automatisierung ist ebenfalls von Vorteil bei der Einstellung des definierten Anpressdrucks. Die Möglichkeit der Automatisierung und wiederholgenauen Herstellung, ist außerdem für eine industrielle Serienfertigung integrierter mikrofluidischer Systeme vorteilhaft.

Das aus dem erfindungsgemäßen Verfahren resultierende integrierte mikrofluidische System kann weiterhin mit einer Deckelung, beispielsweise einer Glasplatte oder einer Polymerplatte oder -folie, insbesondere einer PDMS-Folie oder einer Polystyrol- oder Pyrexplatte, oder einer durch Spritzgießen oder Tiefenätzen oder Blasformen oder Prägen, insbesondere Heißprägen, strukturierten Glasplatte oder Polymerfolie oder -platte versehen werden. Hierdurch kann vorteilhafterweise das Elektronik-Substrat eingehäust und vor äußeren Einwirkungen geschützt werden.

Die vorstehend beschriebenen erfindungsgemäßen Verfahrensvarianten können gegebenenfalls in Kombination miteinander realisiert werden. Hinsichtlich weiterer Merkmale des erfindungsgemäßen Verfahrens wird hiermit explizit auf die Erläuterungen im Zusammenhang mit dem erfindungsgemäßen integrierten mikrofluidischen System und der erfindungsgemäßen Verwendung verwiesen.

Erfindungsgemäß wird weiterhin ein integriertes mikrofluidisches System, insbesondere hergestellt nach dem erfindungsgemäßen Verfahren, mindestens umfassend ein mikrofluidisches Substrat und eine Elektronik-Komponente, die jeweils mindestens ein fluidisches und mindestens ein elektrisches Anschlusselement auf der gleichen Oberfläche aufweisen, vorgeschlagen, wobei das Elektronik-Substrat mit seiner Verbindungsoberfläche auf der Verbindungsoberfläche des mikrofluidischen Substrats angeordnet ist und jeweils die fluidischen und elektrischen Anschlusselemente zur fluidischen und elektrischen Kontaktierung mindestens teilweise überlappend angeordnet sind, wobei die fluidische Ankontaktierung und Abdichtung ein erstes Klebemittel und die elektrische Ankontaktierung ein zweites Klebemittel umfasst, welches von dem ersten Klebemittel verschieden ist.

Mit anderen Worten ist das mikrofluidische Substrat mit dem Elektronik-Substrat fluidisch dicht und elektrisch funktionell mittels einer Flip-Chip-Verbindung mit zwei voneinander verschiedenen und nacheinander aushärtenden, Klebemitteln ankontaktiert und verbunden.

Die fluidischen und elektrischen Anschlusselemente auf der jeweiligen Verbindungsoberfläche des mikrofluidischen Substrats und des Elektronik-Substrats sind zweckmäßigerweise jeweils derart voneinander beabstandet angeordnet, dass ein Kurzschluss durch ein Fluid, welches in das erfindungsgemäße mikrofluidische System eingebracht wird, unterbunden wird.

In Rahmen einer anderen Ausgestaltung des erfindungsgemäßen integrierten mikrofluidischen Systems kann die Verbindungsoberfläche des mikrofluidischen Substrats und/oder des Elektronik-Substrats mindestens zwischen dem fluidischen Anschlusselement und dem elektrischen Anschlusselement mindestens ein Trennelement für die Klebemittel aufweisen.

Unter einem Trennelement für die Klebemittel wird erfindungsgemäß eine Einrichtung verstanden, die geeignet ist das erste und das zweite Klebemittel voneinander zu trennen und eine Vermischung und/oder gegenseitige Beeinflussung der beiden Klebemittel zu unterbinden.

Im Rahmen einer bevorzugten Ausgestaltung kann das Trennelement ein Abstandshalterelement, insbesondere eine oder mehrere Barrieren und/oder mindestens eine Nut zur Aufnahme der jeweiligen Klebemittel und/oder eine Oberflächenmodifizierung der Verbindungsoberfläche sein. Hierdurch kann vorteilhafterweise eine Vermischung der Klebemittel und damit gegebenenfalls eine funktionelle Beeinträchtigung derselben vermieden werden.

Als Barrieren können eine oder mehrere Erhebungen, beispielsweise in Form von Stegen, auf der jeweiligen Oberfläche zwischen dem fluidischen und dem elektrischen Anschlusselement angeordnet sein. Eine, um das fluidische Anschlusselement herum angeordnete Nut kann als Klebstoffgraben zur Aufnahme des fluidisch abdichtenden Klebemittels dienen.

Eine Oberflächenmodifizierung der Verbindungsoberfläche des mikrofluidischen und/oder des Elektronik-Substrats kann beispielsweise derart ausgebildet sein, dass sie die Benetzung der jeweiligen Oberfläche mit Klebemitteln beeinflusst und auf definierte Bereiche begrenzt.

In einer Ausführungsform der Erfindung kann das Elektronik-Substrat vorteilhafterweise ein Sensor- oder Aktorchip, insbesondere aus Silizium, sein. Beispielhaft kann das Elektronik-Substrat ein Fluss-Sensor sein.

Hinsichtlich weiterer Merkmale des erfindungsgemäßen integrierten mikrofluidischen Systems wird hiermit explizit auf die Erläuterungen im Zusammenhang mit dem erfindungsgemäßen Verfahren und der erfindungsgemäßen Verwendung verwiesen.

Ferner betrifft die vorliegende Erfindung die Verwendung eines erfindungsgemäßen integrierten mikrofluidischen Systems in der Medizintechnik und/oder Mikrobiologie, beispielsweise in der medizinischen Analytik, insbesondere in einem integrierten mikrofluidischen Lab-on-Chip-System.

### Zeichnungen

Die Erfindung wird nachfolgend an Hand von Ausführungsbeispielen in Verbindung mit den Figuren näher erläutert, ohne auf die gezeigten Ausgestaltungen beschränkt zu sein.

### Es zeigt

Fig. 1 einen schräge Draufsicht auf ein erfindungsgemäßes integriertes mikrofluidisches System,
Fig. 2 eine teilexplodierte Ansicht auf das in Figur 1 gezeigte integrierte mikrofluidische System,
Fig. 3a bis 3c eine schematische Darstellung des erfindungsgemäßen Verfahrens,
Fig. 4a eine schräge Draufsicht auf ein mikrofluidisches Substrat mit einer Barriere zwischen dem fluidischen und elektrischen Anschlusselement und
Fig. 4b eine schräge Draufsicht auf ein mikrofluidisches Substrat mit einer Nut zur Aufnahme des ersten, fluidisch abdichtenden Klebemittels.

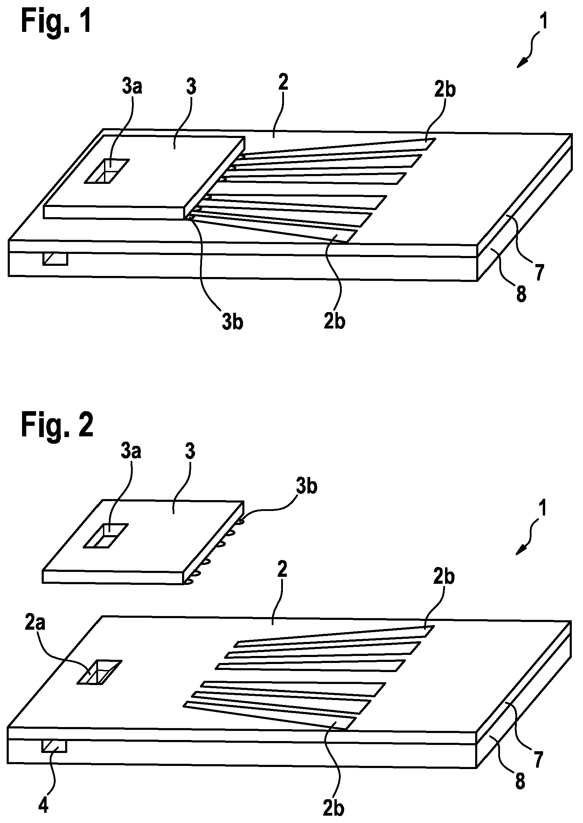

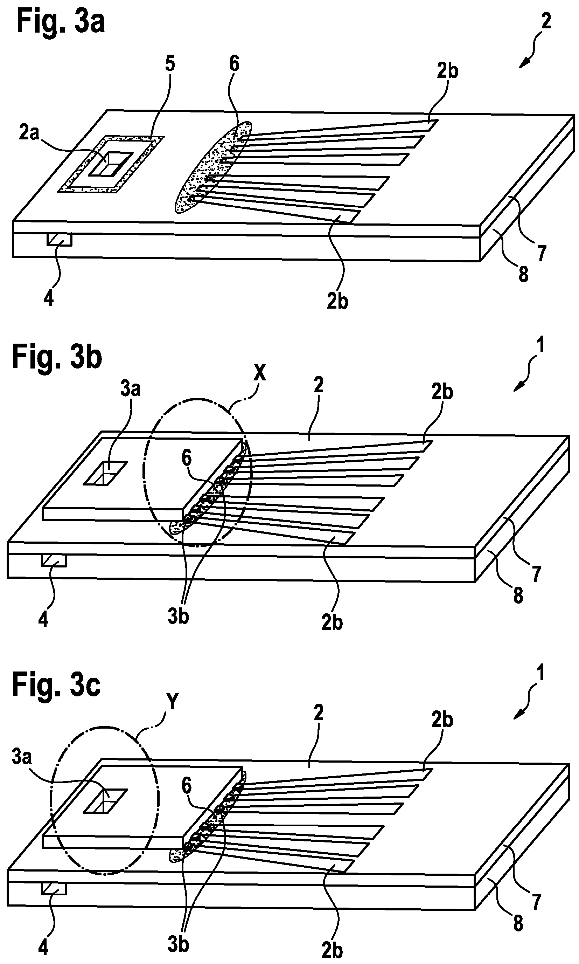

Figur 1 zeigt eine schräge Draufsicht auf ein erfindungsgemäßes integriertes mikrofluidisches System 1, welches ein mikrofluidisches Substrat 2 und ein Elektronik-Substrat 3 umfasst, wobei diese Substrate jeweils mindestens ein fluidisches Anschlusselement 2a (siehe Figur 2), 3a und mindestens ein elektrisches Anschlusselement 2b, 3b auf der jeweils gleichen Oberfläche, der Verbindungsseite, aufweisen. Das Elektronik-Substrat 3 ist mit seiner Verbindungsseite auf der Verbindungsseite des mikrofluidischen Substrats 2 angeordnet und mit dieser verbunden. Die fluidischen Anschlusselemente 2a, 3a und die elektrischen Anschlusselemente 2b, 3b sind zur fluidischen und elektrischen Kontaktierung miteinander überlappend angeordnet. Das mikrofluidische Substrat 2 weist in dieser Ausgestaltung eine mikrofluidische Zugangsöffnung als mikrofluidisches Anschlusselement 2a und Leiterbahnen als elektrische Anschlusselemente 2b auf. Das Elektronik-Substrat 3, welches bevorzugt ein Halbleiterchip, beispielsweise ein Fluss-Sensor ist, weist beispielsweise als mikrofluidisches Anschlusselement 3a eine Membran und als elektrische Anschlusselemente 3b Gold-Stud-Bumps auf. Die Membran des Sensors 3 wird im integrierten mikrofluidischen System 1 der Erfindung von einem darin eingebrachten Fluid von derselben Seite angeströmt, auf der auch die Stud-Bumps 3b mit den Leiterbahnen 2b ankontaktiert sind. Erfindungsgemäß umfasst die fluidisch dichte Ankontaktierung 2a, 3a ein erstes Klebemittel 5 (siehe Figur 3a bis 3c) und die elektrisch funktionelle Ankontaktierung 2b, 3b ein zweites Klebemittel 6 (siehe Figur 3a bis 3c), welches erfindungsgemäß von dem ersten Klebemittel 5 verschieden ist. Das mikrofluidische Substrat 2 ist erfindungsgemäß bevorzugt ein Polymersubstrat, welches auch aus zwei oder mehr Polymerschichten 7, 8 aufgebaut sein kann.

Fig. 2 zeigt eine teilexplodierte Ansicht auf das in Figur 1 gezeigte integrierte mikrofluidische System 1. Das mikrofluidische Substrat 2 ist dabei getrennt vom Elektronik-Substrat 3 gezeigt. Das mikrofluidische Substrat 2, welches bevorzugt als Polymersubstrat ausgestaltet ist, weist eine mikrofluidische Zugangsöffnung 2a zu einem mikrofluidischen Kanal 4 auf. Die Figur 2 verdeutlicht außerdem, dass das mikrofluidische Substrat 2 auch aus zwei oder mehr Schichten 7, 8 aufgebaut sein kann. Die Verbindungsseite des mikrofluidischen Substrats 2 trägt als elektrische Anschlusselemente 2b mehrere Leiterbahnen. Vorteilhafterweise kann das Elektronik-Substrat 3, welches bevorzugt ein Halbleiterchip, besonders bevorzugt ein Sensor- oder Aktorchip ist, insbesondere anhand der Leiterbahnen 2b optisch, insbesondere für eine optimale Verbindung mit den Stud-Bumps 3b, auf einfache Weise ausgerichtet (alignt) werden. Vorteilhafterweise ist dies erfindungsgemäß auch automatisiert möglich, was insbesondere auch für eine Serienfertigung von Bedeutung ist. Die Präzision der Ausrichtung und damit auch die Qualität der resultierenden elektrischen Verbindungen und letztendlich der resultierenden integrierten mikrofluidischen Systeme 1 kann damit verbessert werden. Der Abstand der Zugangsöffnung 2a zu den Leiterbahnen 2b sowie der Membran 3a zu den Stud-Bumps 3b sind zum einen so gewählt, dass diese nach dem Aufsetzen und Fügen der Substrate 2, 3 zum Zwecke der Kontaktierung überlappen und zum anderen ein Kurzschluss durch ein Fluid ausgeschlossen ist.

Die Figuren 3a bis 3c zeigen eine schematische Darstellung des erfindungsgemäßen Verfahrens. Zunächst werden erfindungsgemäß in einem Schritt A) und B) das erste fluidisch abdichtende Klebemittel 5 und das zweite Klebemittel 6 an geeigneten Stellen, beispielsweise auf die Verbindungsseite des mikrofluidischen Substrats 2 aufgetragen. Besonders geeignet hierfür sind Dispens-, Jet- und/ oder Stempelprozesse, da diese auch den gleichzeitigen Auftrag unterschiedlicher Klebemittel erlauben und vorteilhafterweise einer Automatisierung zugänglich sind. Fig. 3a zeigt eine schräge Draufsicht auf ein mikrofluidisches Substrat 2 nach dem Auftrag des ersten Klebemittels 5 um die fluidische Zugangsöffnung 2a herum und einem Auftrag des zweiten Klebemittels 6 an dem der Zugangsöffnung 2a zugewandten Ende der Leiterbahnen 2b. Zweckmäßigerweise wird ein erstes Klebemittel gewählt, welches unter den gewählten Prozessbedingungen, insbesondere gegebenenfalls notwendigen Temperatureinwirkungen, nicht kapillarisiert. Hierdurch kann vorteilhafterweise verhindert werden, dass fluidische Zugangsöffnungen 2a verstopfen. Vorteilhafterweise kann das Elektronik-Substrat 3, beispielsweise ein Fluss-Sensor, insbesondere anhand der Leiterbahnen 2b optisch auf einfache Weise ausgerichtet (alignt) und im Schritt C) auf das mikrofluidische Substrat aufgesetzt werden. Dies gewährleistet eine optimale Verbindung der Leiterbahnen 2b mit den Stud-Bumps 3b. Das Aufbringen des Elektronik-Substrats 3 umfasst im erfindungsgemäßen Verfahren im Schritt C) außerdem, dass dieses mit einer geeigneten Krafteinbringung aufgedrückt wird, so dass die Stud-Bumps 3b mit den Leiterbahnen 2b elektrisch kontaktiert. Figur 3b verdeutlicht, dass im Schritt D) während des Aufdrückens mit einem definierten und geeigneten Druck zunächst das zweite Klebemittel 6 im mit X gekennzeichneten Bereich ausgehärtet und somit eine sichere elektrische Kontaktierung gewährleistet wird. Nachfolgend wird dann, wie Fig. 3c verdeutlicht, im mit Y gekennzeichneten Bereich das erste Klebemittel 5 für die fluidische Abdichtung und Kontaktierung ausgehärtet. Mögliche Klebemittel-Systeme sind unterschiedliche Licht- bzw. Temperaturhärtende Klebestoffe oder Kombinationen daraus. So kann zum Beispiel das zweite Klebemittel 6 zunächst thermisch ausgehärtet werden und nachfolgend das erste fluidisch abdichtende Klebemittel 5 mit UV-Licht. Alternativ kann das zweite Klebemittel 6 ein thermisch schnell reaktiver Klebstoff sein, während das erste fluidisch abdichtende Klebemittel ein relativ dazu thermisch langsam aushärtender Klebstoff ist.

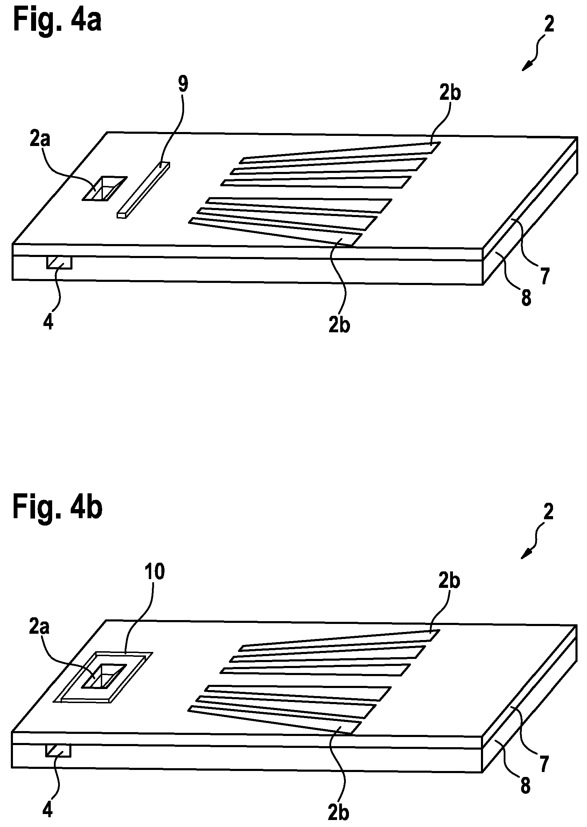

Fig. 4a und Fig. 4b zeigen jeweils eine schräge Draufsicht auf ein mikrofluidisches Substrat 2 mit einem Trennelement für die Klebemittel. Die in Figur 4a gezeigte Ausführungsform ist mit einem Abstandshalterelement 9, insbesondere einer Barriere, zwischen der fluidischen Zugangsöffnung 2a und den Leiterbahnen 2b ausgestaltet. Die Barriere 9 ist in Form eines Steges zwischen der fluidischen Zugangsöffnung 2a und den Leiterbahnen 2b angeordnet.

In Figur 4b weist in einer alternativen Ausführungsform das mikrofluidische Substrat 2 eine, um das fluidische Anschlusselement 2a herum angeordnete, Nut 10 auf, die als Klebstoffgraben zur Aufnahme des fluidisch abdichtenden Klebemittels dient. Durch solche Abstandshalterelemente 9 und/oder Klebstoffgräben 10 kann vorteilhafterweise eine Vermischung der Klebemittel 5, 6 und damit gegebenenfalls eine gegenseitige funktionelle Beeinträchtigung derselben vermieden werden.

Zusammenfassend wird erfindungsgemäß ein Verfahren zur Herstellung eines mikrofluidischen Systems bereitgestellt, in dem die konventionelle Flip-Chip-Montage mit geringen Anpassungen vorteilhafterweise für die gleichzeitige fluidisch dichte und elektrisch funktionelle Anbindung von Elektronik-Substraten, insbesondere Halbleiterchips, an mikrofluidische Substrate verwendet wird. Die gleichzeitige fluidische und elektrische Ankontaktierung wird dabei im bereitgestellten Klebe-Flip-Chip-Verfahren, insbesondere über einen zweistufigen Klebeprozess realisiert.

## Patentansprüche

1. Verfahren zur Herstellung eines integrierten mikrofluidischen Systems (1), mindestens umfassend ein mikrofluidisches Substrat (2) und ein Elektronik-Substrat (3), insbesondere einen Halbleiterchip, wobei das mikrofluidische Substrat (2) und das Elektronik-Substrat (3) jeweils mindestens ein fluidisches Anschlusselement (2a, 3a) und mindestens ein elektrisches Anschlusselement (2b, 3b) auf einer Verbindungsoberfläche aufweisen, mittels einer Flip-Chip-Verbindung, das folgende Schritte umfasst:
A) Aufbringen eines fluidisch abdichtenden Klebemittels (5) zur Herstellung einer fluidischen Kontaktierung auf die Verbindungsoberfläche des mikrofluidischen Substrats (2) und/oder des Elektronik-Substrats (3);
B) Aufbringen eines zweiten Klebemittels (6) zur elektrischen Verbindung auf die Verbindungsoberfläche des mikrofluidischen Substrats (2) und/oder des Elektronik-Substrats (3), wobei das zweite Klebemittel (6) vom ersten Klebemittel (5) verschieden ist,
C) Aufsetzen und Andrücken des Elektronik-Substrats (3) mit seiner Verbindungsoberfläche auf die Verbindungsoberfläche des mikrofluidischen Substrats (2) mit einem definierten Anpressdruck, wobei jeweils die fluidischen Anschlusselemente (2a, 3a) und elektrischen Anschlusselemente (2b, 3b) zur fluidischen und elektrischen Kontaktierung mindestens teilweise überlappend angeordnet sind und
D) Aushärten des ersten und des zweiten Klebemittels (5, 6), **dadurch gekennzeichnet, dass** das zweite Klebemittel (6), insbesondere unter dem in Schritt C) ausgeübten definierten Anpressdruck, zuerst aushärtet.

2. Verfahren nach Anspruch 1, **dadurch gekennzeichnet, dass** die Aufbringung des ersten und des zweiten Klebemittels (5, 6) in Schritt A) und B) gleichzeitig, bevorzugt auf die Verbindungsoberfläche des mikrofluidischen Substrats (2), erfolgt.

3. Verfahren nach Anspruch 1 oder 2, **dadurch gekennzeichnet, dass** die Aufbringung der Klebemittel (5, 6) in Schritt A) und Schritt B) durch einen Dispens- und/oder einen Stempelprozess und/oder einen Jetprozess erfolgt.

4. Verfahren nach einem der Ansprüche 1 bis 3, **dadurch gekennzeichnet, dass** das Aushärten der Klebemittel (5, 6) in Schritt D) in einem Temperaturbereich bis maximal 150 °C durchgeführt wird.

5. Verfahren nach einem der Ansprüche 1 bis 4, **dadurch gekennzeichnet, dass** das zweite Klebemittel (6) beim Aushärten in Schritt D) einer Schrumpfung unterliegt.

6. Verfahren nach einem der Ansprüche 1 bis 5, **dadurch gekennzeichnet, dass** das Aufsetzen des Elektronik-Substrats (3) mit seiner Verbindungsoberfläche auf die Verbindungsoberfläche des mikrofluidischen Substrats (2) in Schritt C), insbesondere automatisiert, anhand optischer Erkennungsmarken auf der Verbindungsoberfläche des mikrofluidischen Substrats (2) erfolgt, insbesondere anhand der elektrischen Anschlusselemente (2b) auf der Verbindungsoberfläche des mikrofluidischen Substrats (2).

## Claims

1. Method for producing an integrated microfluidic system (1), at least comprising a microfluidic substrate (2) and an electronics substrate (3), in particular a semiconductor chip, the microfluidic substrate (2) and the electronics substrate (3) respectively having at least one fluidic connection element (2a, 3a) and at least one electrical connection element (2b, 3b) on a connecting surface, by means of a flip-chip connection, which comprises the following steps:
A) applying a fluidically sealing adhesive (5) for establishing fluidic contact to the connecting surface of the microfluidic substrate (2) and/or of the electronics substrate (3);
B) applying a second adhesive (6) for electrical connection to the connecting surface of the microfluidic substrate (2) and/or of the electronics substrate (3), the second adhesive (6) being different from the first adhesive (5),
C) placing the electronics substrate (3) with its connecting surface onto the connecting surface of the microfluidic substrate (2) and pressing it with a defined pressing pressure, the fluidic connection elements (2a, 3a) and electrical connection elements (2b, 3b) being arranged at least partially overlapping to create the fluidic and electrical contact, and
D) curing the first and second adhesives (5, 6), **characterized in that** the second adhesive (6) is cured first, in particular under the defined pressing pressure exerted in step C).

2. Method according to Claim 1, **characterized in that** the application of the first and second adhesives (5, 6) in steps A) and B) takes place simultaneously, preferably to the connecting surface of the microfluidic substrate (2).

3. Method according to Claim 1 or 2, **characterized in that** the application of the adhesives (5, 6) in step A) and step B) takes place by a dispensing and/or stamping process and/or a jetting process.

4. Method according to one of Claims 1 to 3, **characterized in that** the curing of the adhesives (5, 6) in step D) is carried out in a temperature range up to a maximum of 150°C.

5. Method according to one of Claims 1 to 4, **characterized in that** the second adhesive (6) is subject to shrinkage during the curing in step D).

6. Method according to one of Claims 1 to 5, **characterized in that** the placing of the electronics substrate (3) with its connecting surface onto the connecting surface of the microfluidic substrate (2) in step C) takes place in particular in an automated manner, on the basis of optical recognition marks on the connecting surface of the microfluidic substrate (2), in particular on the basis of the electrical connection elements (2b) on the connecting surface of the microfluidic substrate (2).

## Revendications

1. Procédé de fabrication d'un système microfluidique intégré (1), comprenant au moins un substrat microfluidique (2) et un substrat électronique (3), en particulier une puce à semi-conducteur, dans lequel le substrat microfluidique (2) et le substrat électronique (3) présentent respectivement au moins un élément de raccordement fluidique (2a, 3a) et au moins un élément de raccordement électrique (2b, 3b) sur une surface de liaison, au moyen d'une liaison flip-chip, qui comprend les étapes suivantes:
A) dépôt d'un adhésif fluidiquement étanche (5) pour la production d'un contact fluidique sur la surface de liaison du substrat microfluidique (2) et/ou du substrat électronique (3);
B) dépôt d'un deuxième adhésif (6) pour la liaison électrique sur la surface de liaison du substrat microfluidique (2) et/ou du substrat électronique (3), dans lequel le deuxième adhésif (6) est différent du premier adhésif (5),
C) application et pression du substrat électronique (3) avec sa surface de liaison sur la surface de liaison du substrat microfluidique (2) avec une pression d'application définie, dans lequel les éléments de raccordement fluidiques (2a, 3a) et les éléments de raccordement électriques (2b, 3b) sont disposés en chevauchement au moins partiel pour le contact fluidique et électrique, et
D) durcissement du premier et du deuxième adhésif (5, 6),
**caractérisé en ce que** le deuxième adhésif (6) durcit en premier lieu, en particulier sous la pression d'application exercée à l'étape C).

2. Procédé selon la revendication 1, **caractérisé en ce que** le dépôt du premier et du deuxième adhésif (5, 6) aux étapes A) et B) est effectué simultanément, de préférence sur la surface de liaison du substrat microfluidique (2).

3. Procédé selon la revendication 1 ou 2, **caractérisé en ce que** le dépôt des adhésifs (5, 6) à l'étape A) et à l'étape B) est effectué par un procédé de distribution et/ou un procédé de marquage et/ou un procédé par jet.

4. Procédé selon l'une quelconque des revendications 1 à 3, **caractérisé en ce que** le durcissement des adhésifs (5, 6) à l'étape D) est opéré dans un domaine de température s'élevant jusque 150°C au maximum.

5. Procédé selon l'une quelconque des revendications 1 à 4, **caractérisé en ce que** le deuxième adhésif (6) subit un retrait lors du durcissement à l'étape D).

6. Procédé selon l'une quelconque des revendications 1 à 5, **caractérisé en ce que** l'application du substrat électronique (3) avec sa surface de liaison sur la surface de liaison du substrat microfluidique (2) à l'étape C) est effectuée, en particulier de façon automatisée, à l'aide de marques de reconnaissance optiques sur la surface de liaison du substrat microfluidique (2), en particulier à l'aide des éléments de raccordement électriques (2b) sur la surface de liaison du substrat microfluidique (2).
